# EUROPEAN PATENT APPLICATION

(11) **EP 4 535 412 A1**
(43) Date of publication of application: **09.04.2025**
(21) Application number: 24168966.0
(22) Date of filing: 08.04.2024
(51) Int. Cl.: H01L 21/768, H01L 23/48, H01L 23/522

(54) **SEMICONDUCTOR DEVICE INCLUDING A THROUGH VIA AND A WIRING LAYER**

(30) Priority: 06.10.2023 KR 20230133769
(71) Applicant: Samsung Electronics Co., Ltd., Suwon-si, Gyeonggi-do 16677 (KR)
(72) Inventor: KWON, Dohyun, 16677 Suwon-si (KR); KIM, Sunoo, 16677 Suwon-si (KR); PARK, Jonghwa, 16677 Suwon-si (KR); BANG, Yongseung, 16677 Suwon-si (KR); LEE, Jaeheon, 16677 Suwon-si (KR)
(74) Representative: Marks & Clerk LLP

(57) **Abstract**

A semiconductor device includes a semiconductor substrate, a first insulating layer disposed on a first surface of the semiconductor substrate, a through via passing through both the semiconductor substrate and the first insulating layer, a protective barrier wall pattern disposed within the first insulating layer and on a sidewall of the through via, a first wiring structure disposed within the first insulating layer and including a first via portion and a first wiring portion, and a second insulating layer disposed on an upper surface of the first insulating layer and at least partially covering an upper surface of the first wiring structure and an upper surface of the protective barrier wall pattern.

## Description

### TECHNICAL FIELD

The present disclosure relates to a semiconductor device, and more particularly, to a semiconductor device including a through via and a wiring layer.

### DISCUSSION OF THE RELATED ART

Stacked semiconductor devices are devices in which multiple semiconductor chips are stacked within a single package. Stacked semiconductor devices may provide higher integration and performance as compared to semiconductor devices in which chips are not stacked. Here, each of the chips of the stacked semiconductor device may include a through via and may be electrically connected to another semiconductor chip or a printed circuit board by the through via. As semiconductor devices become miniaturized, large-capacity, and highly integrated, pitches of metal wires within semiconductor devices have decreased. In this case, the reliability of metal wires or through vias may deteriorate due to errors occurring in manufacturing processes of the metal wires and the through vias.

### SUMMARY

A semiconductor device includes a semiconductor substrate, a first insulating layer disposed on a first surface of the semiconductor substrate, a through via passing through both the semiconductor substrate and the first insulating layer, a protective barrier wall pattern disposed within the first insulating layer and on a sidewall of the through via, a first wiring structure disposed within the first insulating layer and including a first via portion and a first wiring portion, and a second insulating layer disposed on an upper surface of the first insulating layer and at least partially covering an upper surface of the first wiring structure and an upper surface of the protective barrier wall pattern.

A semiconductor device includes a substrate, a first insulating layer disposed on a first surface of the substrate, a through via penetrating the substrate and the first insulating layer, a protective barrier wall pattern disposed within the first insulating layer and at least partially covering a sidewall of an upper portion of the through via, and a first wiring structure disposed within the first insulating layer and including a first via portion and a first wiring portion. An outer sidewall of the protective barrier wall pattern is horizontally spaced apart from a sidewall of the first wiring portion.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1A is a cross-sectional view illustrating a semiconductor device according to embodiments;
FIG. 1B is a plan view illustrating a through via and a protective barrier wall pattern of a semiconductor device;
FIG. 1C is an enlarged cross-sectional view illustrating a region I of the semiconductor device of FIG. 1A, and corresponds to a cross-section taken along line II-II' of FIG. 1B;
FIG. 1D is an enlarged cross-sectional view of a region III of FIG. 1C;
FIG. 1E is a plan view illustrating a planar arrangement of a through via and second via portions of a second through wiring structure, according to embodiments;
FIG. 2 is a cross-sectional view illustrating a semiconductor device according to embodiments; and
FIGS. 3A to 3O are cross-sectional views illustrating a method of manufacturing a semiconductor device, according to embodiments.

### DETAILED DESCRIPTION OF THE EMBODIMENTS

As used herein, the same reference numerals may refer to the same components throughout the description and the drawings. A semiconductor device and a method of manufacturing the same, according to the inventive concept, are described below.

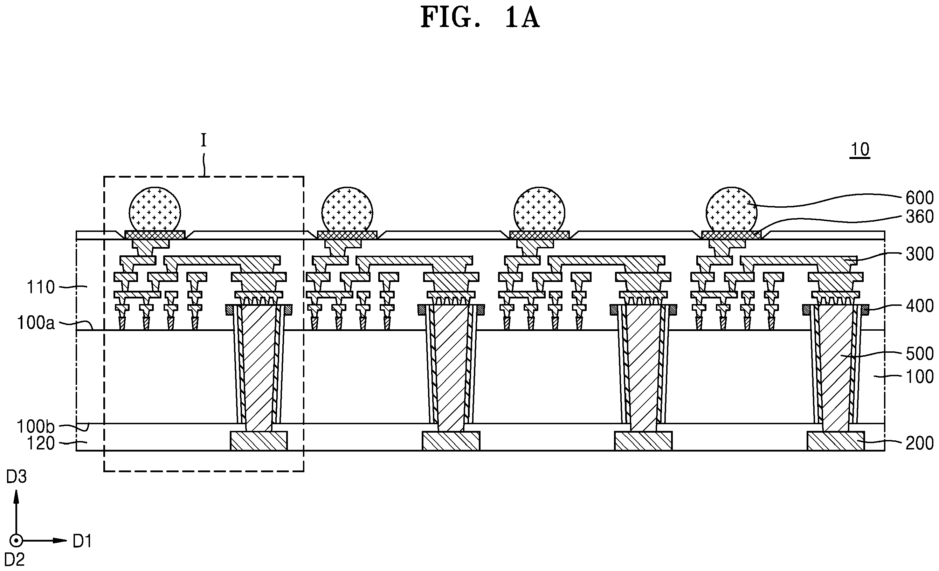

FIG. 1A is a cross-sectional view illustrating a semiconductor device according to embodiments.

Referring to FIG. 1A, a semiconductor device 10 may include a substrate 100, solder ball terminals 600, upper pads 360, through vias 500, a frontside insulating layer 110, wiring structures 300, protective barrier wall patterns 400, a backside insulating layer 120, and lower pads 200. The semiconductor device 10 may be a semiconductor chip including a memory chip, a logic chip, or a combination thereof. The substrate 100 may be a semiconductor substrate. The substrate 100 may include, for example, a semiconductor material such as silicon, germanium, or silicon-germanium. The substrate 100 may have a first surface 100a and a second surface 100b opposite to the first surface 100a. The second surface 100b of the substrate 100 may be substantially parallel to the first surface 100a. The first surface 100a of the substrate 100 may be a front surface. The second surface 100b of the substrate 100 may be a rear surface. The through vias 500 may be disposed within the substrate 100. The through vias 500 may pass through the first surface 100a and the second surface 100b of the substrate 100. The through vias 500 may further extend into a portion of the frontside insulating layer 110 and a portion of the backside insulating layer 120. A first direction D1 may be a direction of extension of the first surface 100a of the substrate 100. A second direction D2 may be a direction of extension of the first surface 100a of the substrate 100 and may intersect with the first direction D1, for example the first and second directions may be non-parallel and, optionally, perpendicular. A third direction D3 may be substantially perpendicular to the first surface 100a of the substrate 100. The third direction D3 may be a vertical direction.

The backside insulating layer 120 may be disposed on the second surface 100b of the substrate 100. The second surface 100b of the substrate 100 may be a lower surface. The backside insulating layer 120 may include a silicon-based insulating material. The silicon-based insulating material may include, for example, silicon oxide, silicon nitride, silicon oxynitride, silicon carbonized oxide, tetraethyl orthosilicate (TEOS), and/or a combination thereof. The lower pads 200 may be disposed on a lower surface of the backside insulating layer 120 or within the backside insulating layer 120. Lower surfaces of the lower pads 200 may be exposed by the backside insulating layer 120. The lower pads 200 may be disposed on lower surfaces of the through vias 500 and may be electrically and respectively connected to the through vias 500. The lower pads 200 may include copper, aluminum, titanium, tantalum, and/or a combination thereof. In the description, being electrically coupled/connected may include a direct coupling/connection or an indirect coupling/connection through other conductive components.

The frontside insulating layer 110 may be disposed on the first surface 100a of the substrate 100. The frontside insulating layer 110 may be a multilayer. The frontside insulating layer 110 may include a silicon-based insulating material. The wiring structures 300 may be disposed within the frontside insulating layer 110 and may be electrically connected to the through vias 500. The wiring structures 300 may include a metal. The upper pads 360 may be disposed on the frontside insulating layer 110 and may be electrically connected to the wiring structures 300. The upper pads 360 may include a metal.

The solder ball terminals 600 may be respectively disposed on upper surfaces of the upper pads 360 and may be respectively connected to the upper pads 360. Hereinafter, the through vias 500, the frontside insulating layer 110, and the wiring structures 300 are described in more detail. For simplicity of description, a single through via 500, a single upper pad 360, a single solder ball terminal 600, and a single lower pad 200 are described.

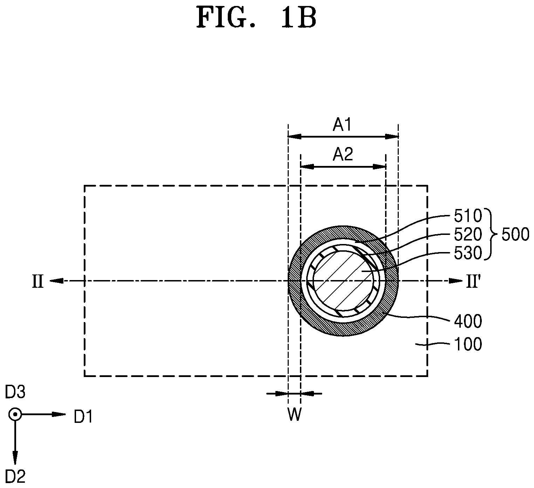

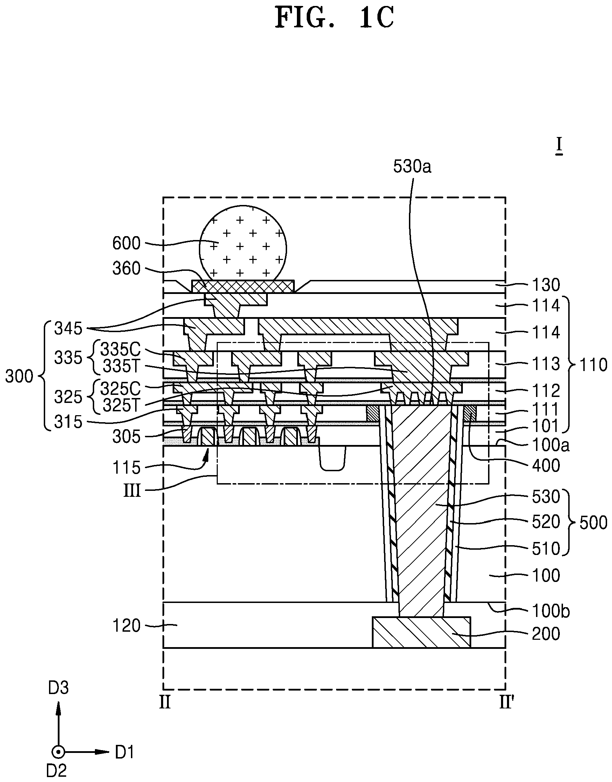

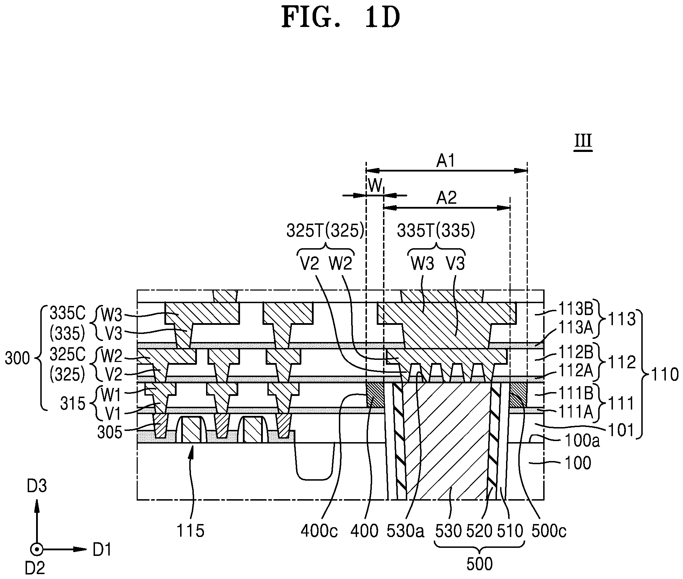

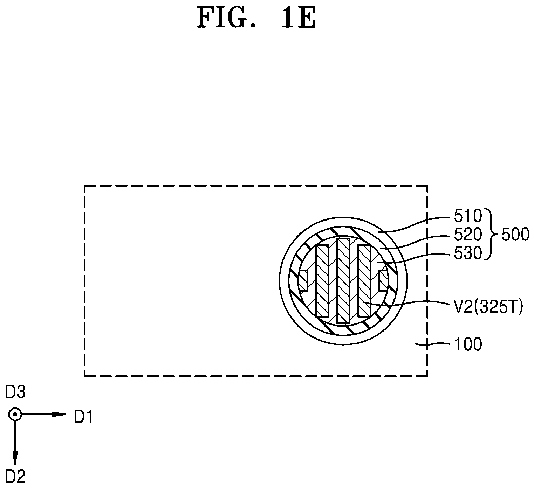

FIG. 1B is a plan view illustrating a through via and a protective barrier wall pattern of a semiconductor device. FIG. 1C is an enlarged cross-sectional view illustrating a region I of the semiconductor device 10 of FIG. 1A, and corresponds to a cross-section taken along line II-II' of FIG. 1B. FIG. 1D is an enlarged cross-sectional view of a region III of FIG. 1C. FIG. 1E is a plan view illustrating a planar arrangement of a through via and second via portions of a second through wiring structure, according to embodiments. Hereinafter, to the extent that an element is not described in detail with respect to this figure, it may be understood that the element is at least similar to a corresponding element that has been described elsewhere within the present disclosure.

Referring to FIGS. 1A, 1B, 1C, and 1D, the semiconductor device 10 may include a substrate 100, a lower pad 200, a backside insulating layer 120, integrated circuits 115, a through via 500, a frontside insulating layer 110, wiring structures 300, an upper pad 360, and a solder ball terminal 600.

As illustrated in FIG. 1C, the integrated circuits 115 may be disposed on a first surface 100a of the substrate 100. The first surface 100a of the substrate 100 may be an upper surface. The integrated circuits 115 may include logic circuits, memory circuits, or combinations thereof. The integrated circuits 115 may include transistors. For example, the integrated circuits 115 may include devices having a three-dimensional structure such as a fin field effect transistor (FinFET), but are not necessarily limited thereto.

The frontside insulating layer 110 and the wiring structures 300 may be disposed on the first surface 100a of the substrate 100. The frontside insulating layer 110 may include a lower insulating layer 101, a first insulating layer 111, a second insulating layer 112, a third insulating layer 113, and fourth insulating layers 114. The wiring structures 300 may include conductive patterns 305, first wiring structures 315, second wiring structures 325, third wiring structures 335, and fourth wiring structures 345.

The lower insulating layer 101 may be disposed on the first surface 100a of the substrate 100 and may cover the integrated circuits 115. The lower insulating layer 101 may include, for example, silicon oxide, tetraethyl orthosilicate (TEOS), silicon nitride, silicon oxynitride, silicon carbonized oxide, and/or silicon carbonitride. The lower insulating layer 101 may be a multilayer.

The semiconductor device 10 may further include the conductive patterns 305. The conductive patterns 305 may be disposed within the lower insulating layer 101 and may be electrically connected to the integrated circuits 115. For example, the conductive patterns 305 may include contact plugs. Each of the conductive patterns 305 may further include a metal wire, a metal via, and/or a combination thereof. The conductive patterns 305 may include cobalt, tungsten, copper, and/or a combination thereof.

The first insulating layer 111 may be disposed on an upper surface of the lower insulating layer 101. As illustrated in FIG. 1D, the first insulating layer 111 may include a first etch stop layer 111A and a first interlayer insulating layer 111B . The first etch stop layer 111A may cover the upper surface of the first lower insulating layer 101. The first etch stop layer 111A may include, for example, TEOS, but is not necessarily limited thereto.

The first interlayer insulating layer 111B may be disposed on an upper surface of the first etch stop layer 111A. The first interlayer insulating layer 111B may include a silicon-based insulating material. An upper surface of the first insulating layer 111 may correspond to an upper surface of the first interlayer insulating layer 111B.

The first wiring structures 315 may be disposed within the first insulating layer 111 and respectively on the conductive patterns 305. The first wiring structures 315 may be laterally spaced apart from each other. When any two components are laterally spaced apart from each other, it may indicate that the two components are horizontally spaced apart from each other. The term "horizontal" may indicate being parallel to the first surface 100a of the substrate 100. The first wiring structures 315 may be circuit wiring structures. The first wiring structures 315 may be electrically connected to the integrated circuits 115 through the conductive patterns 305.

Each of the first wiring structures 315 may include a first via portion V1 and a first wiring portion W1. The first via portion V1 may pass through the first etch stop layer 111A. The first via portion V1 may further pass through a lower portion of the first interlayer insulating layer 111B. The first via portion V1 may be disposed on the conductive pattern 305 corresponding to the first via portion V1 and may be electrically connected to the conductive pattern 305. The first wiring portion W1 may be disposed on the first via portion V1 and may be connected to the first via portion V1. A width of the first wiring portion W1 may be greater than a width of the first via portion V1. The first wiring portion W1 may be disposed within the first interlayer insulating layer 111B. For example, the first wiring portion W1 may pass through the upper surface of the first interlayer insulating layer 111B, and the first via portion V1 may be disposed within an upper portion of the first interlayer insulating layer 111B. In the description, a via may be a component for a vertical connection and a wire may be a component for a horizontal connection. The term "vertical" may indicate being perpendicular to the first surface 100a of the substrate 100.

Upper surfaces of the first wiring structures 315 may be coplanar with the upper surface of the first interlayer insulating layer 111B. The upper surface of each of the first wiring structures 315 may correspond to an upper surface of the first wiring portion W1. The first wiring structures 315 may include, for example, copper, titanium, tantalum, and/or alloys thereof.

The through via 500 may be disposed within the substrate 100. As illustrated in FIG. 1C, a lower portion of the through via 500 may extend into the backside insulating layer 120, and an upper portion of the through via 500 may extend into the lower insulating layer 101. As illustrated in FIG. 1C, a width of an upper surface of the through via 500 may be greater than a width of a lower surface of the through via 500. The upper surface of the through via 500 may be coplanar with the upper surface of the first interlayer insulating layer 111B.

The through via 500 may include a conductive via 530, a barrier layer 520, and an isolation layer 510. The conductive via 530 may include a metal such as copper. The barrier layer 520 may be disposed on sidewalls of the conductive via 530 and may extend along the sidewalls of the conductive via 530. For example, the barrier layer 520 may be disposed between the conductive via 530 and the substrate 100, and may be disposed between the conductive via 530 and the lower insulating layer 101 and between the conductive via 530 and the first insulating layer 111. The barrier layer 520 may prevent a metal included in the conductive via 530 from being diffused into the substrate 100. The barrier layer 520 may include a different metal from the conductive via 530. For example, the barrier layer 520 may include titanium (Ti), titanium nitride (TiN), tantalum (Ta), and/or tantalum nitride (TaN). Being electrically connected to the through via 500 may indicate being electrically connected to the conductive via 530 or the barrier layer 520.

The isolation layer 510 may be provided along an outer sidewall of the barrier layer 520. For example, the isolation layer 510 may be disposed between the barrier layer 520 and the substrate 100, and may be disposed between the barrier layer 520 and the lower insulating layer 101 and between the barrier layer 520 and the first insulating layer 111. The isolation layer 510 may include a silicon-containing insulating material. For example, the isolation layer 510 may include a low dielectric material such as porous silicon oxide, siloxane, or a silsesquioxane-based material. The isolation layer 510 may electrically isolate the conductive via 530 from the substrate 100.

A protective barrier wall pattern 400 may be disposed between the first insulating layer 111 and the through via 500. The protective barrier wall pattern 400 may cover at least a portion of a sidewall 500c of the upper portion of the through via 500. For example, as illustrated in FIG. 1D, the protective barrier wall pattern 400 may be disposed on the upper surface of the first etch stop layer 111A and may be disposed between the first interlayer insulating layer 111B and the through via 500.

The protective barrier wall pattern 400 may have an inner sidewall and an outer sidewall opposite each other. The inner sidewall of the protective barrier wall pattern 400 may be in physical contact with the through via 500. The outer sidewall of the protective barrier wall pattern 400 may be covered by the first interlayer insulating layer 111B. A width W of the protective barrier wall pattern 400 may be within a range of from 450 µm to 550 µm. The width W of the protective barrier wall pattern 400 may correspond to a distance between the outer sidewall and the inner sidewall of the protective barrier wall pattern 400. The outer sidewall of the protective barrier wall pattern 400 may have a first outer sidewall and a second outer sidewall opposite each other. An outer diameter A1 of the protective barrier wall pattern 400 may be a distance between the first outer sidewall and the second outer sidewall of the protective barrier wall pattern 400. The outer diameter A1 of the protective barrier wall pattern 400 may be greater than a width A2 of the through via 500. The difference between the outer diameter A1 of the protective barrier wall pattern 400 and the width A2 of the through via 500 may be within a range of from 0.5 µm to 2 µm.

As illustrated in FIG. 1B, the protective barrier wall pattern 400 may at least partially surround the through via 500 in a plan view. A planar shape of the protective barrier wall pattern 400 may correspond to a planar shape of the through via 500, for example the protective barrier wall pattern 400 and the through via 500 may have corresponding shapes in a horizontal cross-section taken through the protective barrier wall pattern 400 and the through via 500. For example, the through via 500 may have a circular or elliptical planar shape. The protective barrier wall pattern 400 may have a closed-loop or donut shape.

As illustrated in FIG. 1D, the protective barrier wall pattern 400 may be laterally spaced apart from the first wiring structures 315. For example, the outer sidewall of the protective barrier wall pattern 400 may be horizontally spaced apart from a sidewall of the first wiring portion W1. The first interlayer insulating layer 111B may be disposed between the protective barrier wall pattern 400 and the first wiring structures 315.

A lower surface of the protective barrier wall pattern 400 may be in contact with the upper surface of the first etch stop layer 11 1A. An upper surface of the protective barrier wall pattern 400 may be coplanar with the upper surface of the through via 500, the upper surface of the first interlayer insulating layer 111B, and the upper surfaces of the first wiring structures 315. The upper surface of the through via 500 may include an upper surface 530a of the conductive via 530. The upper surface of the through via 500 may further include an upper surface of the barrier layer 520 and an upper surface of the isolation layer 510. Surfaces of certain components being coplanar with each other may include the surfaces of the components being disposed at substantially the same level and the surfaces of the components having a difference in level within a process error range.

The protective barrier wall pattern 400 may include a different insulating material from the first etch stop layer 111A and the first interlayer insulating layer 111B. For example, the protective barrier wall pattern 400 may include silicon nitride. For example, the protective barrier wall pattern 400 may include silicon oxynitride.

The second insulating layer 112 may be disposed on the first insulating layer 111. The second insulating layer 112 may include a second etch stop layer 112A and a second interlayer insulating layer 112B. The second etch stop layer 112A may cover the upper surface of the first insulating layer 111, the upper surfaces of the first wiring structures 315, and the upper surface of the protective barrier wall pattern 400. For example, the second etch stop layer 112A may be in physical contact with the upper surface of the first insulating layer 111, the upper surfaces of the first wiring structures 315, and the upper surface of the protective barrier wall pattern 400. The second etch stop layer 112A may further cover the upper surface of the through via 500. For example, the second etch stop layer 112A may include a high dielectric material. The high dielectric material may have a higher dielectric constant than silicon oxide. For example, the second etch stop layer 112A may have a higher dielectric constant than the first interlayer insulating layer 111B and the second interlayer insulating layer 112B. For example, the second etch stop layer 112A may include aluminum oxide. However, the material of the second etch stop layer 112A is not necessarily limited thereto.

The second interlayer insulating layer 112B may be disposed on an upper surface of the second etch stop layer 112A. The second interlayer insulating layer 112B may include a silicon-based insulating material. An upper surface of the second insulating layer 112 may correspond to an upper surface of the second interlayer insulating layer 112B. Unlike the illustration, the second etch stop layer 112A may be omitted, and the second interlayer insulating layer 112B may cover the upper surface of the first insulating layer 111, the upper surfaces of the first wiring structures 315, the upper surface of the through via 500, and the upper surface of the protective barrier wall pattern 400.

The second wiring structures 325 may be disposed within the second insulating layer 112. Each of the second wiring structures 325 may include a second via portion V2 and a second wiring portion W2. The second via portion V2 may pass through the second etch stop layer 112A. The second via portion V2 may further pass through a lower portion of the second interlayer insulating layer 112B. The second wiring portion W2 may be disposed on the second via portion V2 and may be connected to the second via portion V2. A width of the second wiring portion W2 may be greater than a width of the second via portion V2. The second wiring portion W2 may be disposed within the second interlayer insulating layer 112B. For example, the second wiring portion W2 may pass through an upper portion of the second interlayer insulating layer 112B. The upper surface of each of the second wiring structures 325 may correspond to an upper surface of the corresponding second wiring portion W2. The second wiring structures 325 may include a metal as described in the example of the first wiring structures 315. For example, the second wiring structures 325 may include copper, titanium, tantalum, and/or an alloy thereof.

The second wiring structures 325 may include second circuit wiring structures 325C and a second through wiring structure 325T. The second circuit wiring structures 325C may be disposed on the first wiring structures 315 and may be electrically and respectively connected to the first wiring structures 315. For example, a second via portion V2 of each of the second circuit wiring structures 325C may be disposed between the first wiring portion W1, which corresponds to second via portion V2, and the second wiring portion W2 corresponding to second via portion V2. Accordingly, the second circuit wiring structures 325C may be electrically connected to the integrated circuits 115 through the first wiring structures 315. Upper surfaces of the second circuit wiring structures 325C may be coplanar with the upper surface of the second insulating layer 112.

The second through wiring structure 325T may be disposed on the upper surface of the through via 500 and may be electrically connected to the through via 500. The second through wiring structure 325T may be laterally spaced apart from the second circuit wiring structures 325C. For example, the second interlayer insulating layer 112B may be disposed between the second through wiring structure 325T and the second circuit wiring structures 325C.

The second through wiring structure 325T may include a plurality of second via portions V2 and a second wiring portion W2. The second via portions V2 of the second through wiring structure 325T may be disposed on the upper surface 530a of the conductive via 530 and may be electrically connected to the conductive via 530. The second via portions V2 of the second through wiring structure 325T may be laterally spaced apart from each other. The second insulating layer 112 may be disposed between the second via portions V2 of the second through wiring structure 325T. The second insulating layer 112 may be disposed between the upper surface of the through via 500 (e.g., the upper surface 530a of the conductive via 530) and the second wiring portion W2. Accordingly, the upper surface 530a of the conductive via 530 may be covered by the second etch stop layer 112A and may be in physical contact with the second etch stop layer 112A. For example, the second etch stop layer 112A may cover at least a portion of an upper surface of a center region of the conductive via 530. When the second insulating layer 112 does not include the second etch stop layer 112A, the second interlayer insulating layer 112B may cover the upper surface 530a of the conductive via 530. The center region of the conductive via 530 may correspond to a center region of the through via 500.

Another component might not be disposed between the second through wiring structure 325T and the conductive via 530. For example, the second through wiring structure 325T may be in direct contact with the upper surface 530a of the conductive via 530. Accordingly, a resistance between the conductive via 530 and the second through wiring structure 325T may be reduced. The semiconductor device 10 may exhibit enhanced electrical characteristics, for example the semiconductor device 10 may exhibit a resistance which is reduced, more predictable, and/or which varies across a narrower range.

A level of the upper surface 530a of the conductive via 530 may have a uniform distribution. Accordingly, the second through wiring structure 325T and the conductive via 530 may be well electrically connected to each other, so that electrical characteristics between the second through wiring structure 325T and the conductive via 530 may be further enhanced, for example a resistance between the second through wiring structure 325T and the conductive via 530 may be reduced, may be more predictable, and/or may vary across a narrower range. In addition, electrical characteristics between the second circuit wiring structures 325C and the first wiring structures 315 may be enhanced, for example a resistance between the second circuit wiring structures 325C and the first wiring structures 315 may be reduced, may be more predictable, and/or may vary across a narrower range.

As illustrated in FIG. 1E, the second via portions V2 of the second through wiring structure 325T may form a stripe pattern in a plan view. For example, each of the second via portions V2 of the second through wiring structure 325T may extend in the second direction D2 in a plan view. Each of the second via portions V2 of the second through wiring structure 325T may have a bar shape, a rectangular shape, or a rectangular shape with rounded corners. The second via portions V2 of the second through wiring structure 325T may be spaced apart from each other in the first direction D1. However, an arrangement of the second via portions V2 of the second through wiring structure 325T may be variously modified.

As illustrated in FIG. 1D, the second wiring portion W2 of the second through wiring structure 325T may be disposed on the second via portions V2 of the second through wiring structure 325T. The second wiring portion W2 of the second through wiring structure 325T may be connected to the second via portions V2 of the second through wiring structure 325T. A lower surface of the second wiring portion W2 of the second through wiring structure 325T may be in contact with the second interlayer insulating layer 112B. An upper surface of the second through wiring structure 325T may be coplanar with an upper surface of the second insulating layer 112 and upper surfaces of the second circuit wiring structures 325C.

The third insulating layer 113 may be disposed on the upper surface of the second insulating layer 112, the upper surfaces of the second circuit wiring structures 325C, and an upper surface of the second through wiring structure 325T. The third insulating layer 113 may include a third etch stop layer 113A and a third interlayer insulating layer 113B. The third etch stop layer 113A may cover the upper surface of the second insulating layer 112, the upper surfaces of the second circuit wiring structures 325C, and the upper surface of the second through wiring structure 325T. The third etch stop layer 113A may include a high dielectric material. For example, a dielectric constant of the third etch stop layer 113A may be greater than a dielectric constant of the third interlayer insulating layer 113B. The third interlayer insulating layer 113B may be disposed on the third etch stop layer 113A. The third interlayer insulating layer 113B may include a silicon-based insulating material. Unlike the illustration, the third insulating layer 113 might not include the third etch stop layer 113A. In this case, the third interlayer insulating layer 113B may be in physical contact with the upper surface of the second insulating layer 112, the upper surfaces of the second circuit wiring structures 325C, and the upper surface of the second through wiring structure 325T.

The third wiring structures 335 may be disposed within the third insulating layer 113. Each of the third wiring structures 335 may include a third via portion V3 and a third wiring portion W3. The third via portion V3 may pass through the third etch stop layer 113A. The third via portion V3 may further pass through a lower portion of the third interlayer insulating layer 113B. The third wiring portion W3 may be disposed on the third via portion V3 and may be connected to the third via portion V3. A width of the third wiring portion W3 may be greater than a width of the third via portion V3. The third wiring portion W3 may be disposed within the third interlayer insulating layer 113B. An upper surface of each of the third wiring structures 335 may correspond to an upper surface of the third wiring portion W3. The third wiring structures 335 may include a metal as described in the example of the second wiring structures 325.

The third wiring structures 335 may include third circuit wiring structures 335C and a third through wiring structure 335T. The third circuit wiring structures 335C may be disposed on the second circuit wiring structures 325C and may be electrically connected to the second circuit wiring structures 325C. For example, the third via portion V3 of each of the third circuit wiring structures 335C may be disposed between the second wiring portion W2 of the corresponding second circuit wiring structure 325C and the corresponding third wiring portion W3. Accordingly, the third circuit wiring structures 335C may be electrically connected to the integrated circuits 115 through the second circuit wiring structures 325C. Upper surfaces of the third circuit wiring structures 335C may be coplanar with an upper surface of the third insulating layer 113.

The third through wiring structure 335T may be disposed on the upper surface of the second through wiring structure 325T. The third through wiring structure 335T may be laterally spaced apart from the third circuit wiring structures 335C. For example, the third interlayer insulating layer 113B may be disposed between the third through wiring structure 335T and the third circuit wiring structures 335C. For example, the third via portion V3 of the third through wiring structure 335T may be disposed between the second wiring portion W2 of the second through wiring structure 325T and the third wiring portion W3 of the third through wiring structure 335T. The third through wiring structure 335T may be electrically connected to the through via 500 through the second through wiring structure 325T. The upper surface of the third through wiring structure 335T may be coplanar with the upper surface of the third insulating layer 113 and the upper surfaces of the third circuit wiring structures 335C, but is not necessarily limited thereto.

As illustrated in FIG. 1C, the fourth insulating layer 114 may be disposed on the third insulating layer 113, the third circuit wiring structures 335C, and the third through wiring structure 335T. The fourth insulating layer 114 may include a silicon-based insulating material, but is not necessarily limited thereto. The fourth insulating layer 114 may further include an etch stop layer. A plurality of fourth insulating layers 114 may be provided. The plurality of fourth insulating layers 114 may be stacked on the third insulating layer 113. The lowermost fourth insulating layer 114 may cover the upper surface of the third insulating layer 113, the upper surfaces of the third circuit wiring structures 335C, and the upper surface of the third through wiring structure 335T.

Fourth wiring structures 345 may be disposed within the fourth insulating layers 114. Each of the fourth wiring structures 345 may include a fourth via portion and/or a fourth wiring portion. The fourth wiring portion may be disposed on the fourth via portion and may be connected to the fourth via portion. A width of the fourth wiring portion may be greater than a width of the fourth via portion. The fourth wiring structures 345 may include a metal as described in the example of the third wiring structures 335. The fourth wiring structures 345 may include a plurality of stacked fourth wiring structures 345. The number of stacked fourth wiring structures 345 is not necessarily limited to the illustration and may be variously modified. The fourth wiring structures 345 may be electrically connected to the third wiring structures 335. The third through wiring structure 335T may be electrically connected to the third circuit wiring structures 335C through the fourth wiring structures 345. Accordingly, the through via 500 may be electrically connected to the integrated circuits 115 through the wiring structures 300. For example, the through via 500 may be electrically connected to the integrated circuits 115 through the second through wiring structure 325T, the third through wiring structure 335T, the fourth wiring structures 345, the second and third circuit wiring structures 325C, 335C, the first wiring structures 315, and the conductive pattern 305. FIG. 1C illustrates that the third through wiring structure 335T and at least one third circuit wiring structure 335C are electrically connected to each other by any one of the lowermost fourth wiring structures 345, but the inventive concept is an example and is not necessarily limited thereto. For example, the third through wiring structure 335T and at least one third circuit wiring structure 335C may be electrically connected to each other by at least one of the fourth wiring structures 345 on the lowermost fourth wiring structures 345.

An upper pad 360 may be disposed on any one of the uppermost fourth wiring structures 345 and on the uppermost fourth insulating layer 114. The upper pad 360 may be electrically connected to the integrated circuits 115 and the through via 500 through the wiring structures 300. For example, the upper pad 360 may be electrically connected to the integrated circuits 115 through the fourth wiring structures 345, the second and third circuit wiring structures 325C and 335C, the first wiring structures 315, and the conductive patterns 305. The upper pad 360 may be electrically connected to the through via 500 through the fourth wiring structures 345 and the second and third through wiring structures 325T and 335T. Here, the electrical connection between the upper pad 360 and the through via 500 may be made further via the third circuit wiring structure 335C and/or the second circuit wiring structure 325C, but is not necessarily limited thereto. The upper pad 360 may include different metal from the fourth wiring structures 345. For example, the upper pad 360 may include aluminum, chromium, nickel, or a combination thereof, but is not necessarily limited thereto. The upper pads 360 may be solder pads, but are not necessarily limited thereto.

The semiconductor device 10 may further include the solder ball terminal 600. The solder ball terminal 600 may be disposed on the upper pad 360. The solder ball terminal 600 may be electrically connected to the integrated circuits 115 and the through via 500 through the wiring structures 300. The solder ball terminals 600 may include a metal such as a solder material. The solder material may include, for example, tin (Sn), silver (Ag), zinc (Zn), and/or an alloy thereof. As another example, the semiconductor device 10 might not include the solder ball terminal 600.

The semiconductor device 10 may further include a protective insulating layer 130. The protective insulating layer 130 may be disposed on an upper surface of the uppermost fourth insulating layer 114 and may expose the upper pad 360 and the solder ball terminal 600. The protective insulating layer 130 may include insulating polymer or silicon nitride.

The lower pad 200 and the backside insulating layer 120 may be disposed on the second surface 100b of the substrate 100. An upper surface and sidewalls of the lower pad 200 may be covered by the backside insulating layer 120. A lower surface of the lower pad 200 may be exposed by the backside insulating layer 120. The lower pad 200 may be disposed on a lower surface of the conductive via 530 and may be electrically connected to the conductive via 530. For example, the lower pad 200 may be electrically connected to the through via 500. The barrier layer 520 and the isolation layer 510 might not extend between the conductive via 530 and the backside insulating layer 120. In this case, the backside insulating layer 120 may further cover a sidewall of a lower portion of the conductive via 530. However, the inventive concept is not necessarily limited thereto. The lower pad 200 may be electrically connected to the integrated circuits 115 and the solder ball terminal 600 through the conductive via 530 and the wiring structures 300. The lower pad 200 may be electrically connected to another semiconductor device or semiconductor chip.

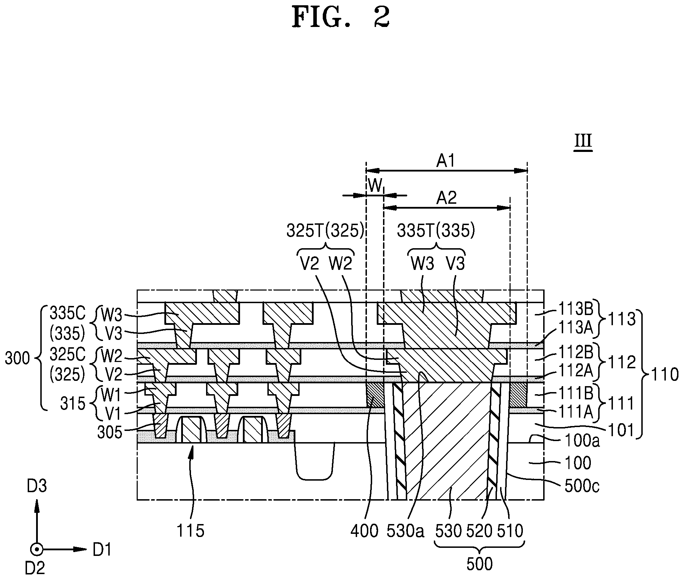

FIG. 2 is a cross-sectional view illustrating a semiconductor device according to embodiments and corresponds to an enlarged view of a region III of FIG. 1C. Hereinafter, to the extent that an element is not described in detail with respect to this figure, it may be understood that the element is at least similar to a corresponding element that has been described elsewhere within the present disclosure.

Referring to FIG. 2 together with FIGS. 1A to 1C, the semiconductor device may include a substrate 100, integrated circuits 115, a through via 500, a frontside insulating layer 110, and wiring structures 300. The semiconductor device may include the upper pads 360, the backside insulating layer 120, and the lower pads 200 as illustrated in FIGS. 1B and 1C. The wiring structures 300 may include first to fourth wiring structures 345. The second wiring structures 325 may include a second through wiring structure 325T and second circuit wiring structures 325C.

The second through wiring structure 325T may include a single second via portion V2 and a single second wiring portion W2. For example, the second via portion V2 of the second through wiring structure 325T may be disposed between a conductive via 530 and the second wiring portion W2 of the second through wiring structure 325T and may be electrically connected to the conductive via 530 and the second wiring portion W2. The second via portion V2 of the second through wiring structure 325T may have a circular shape in a plan view. A second insulating layer 112 may be spaced apart from a center region of an upper surface of the through via 500.

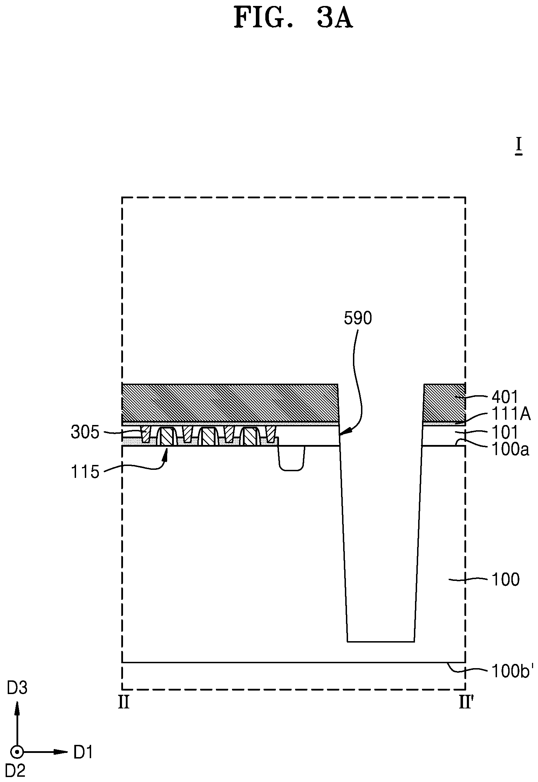

FIGS. 3A to 3O are cross-sectional views illustrating a method of manufacturing a semiconductor device, according to embodiments and correspond to enlarged views of the region I of FIG. 1A.

Referring to FIG. 3A, a substrate 100 may be provided. Integrated circuits 115, a lower insulating layer 101, and a first etch stop layer 111A may be formed on a first surface 100a of the substrate 100. A protective layer 401 may be formed on the first etch stop layer 111A. The protective layer 401 may be formed by, for example, a deposition process, but is not necessarily limited thereto. For example, the protective layer 401 may include silicon nitride and/or silicon oxynitride. The protective layer 401 may have a relatively large thickness.

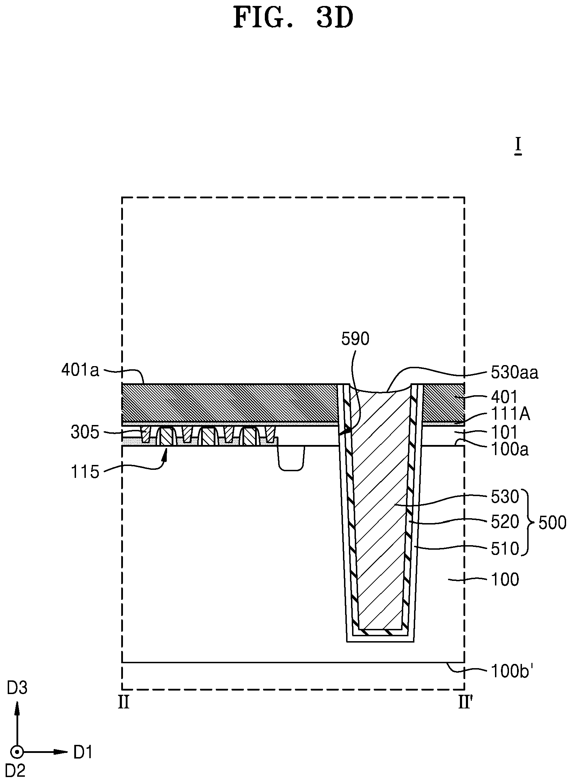

A through hole 590 may be formed within the protective layer 401, the first etch stop layer 111A, the lower insulating layer 101, and the substrate 100. The through hole 590 may be formed by an etching process. The through hole 590 might not pass through a second surface 100b' of the substrate 100. A bottom surface of the through hole 590 may be disposed within the substrate 100. A sidewall of the through hole 590 may correspond to an inner sidewall of the protective layer 401, an inner sidewall of the first etch stop layer 111A, an inner sidewall of the lower insulating layer 101, and an inner sidewall of the substrate 100. For example, the through hole 590 may be formed by a via-middle process. For example, after the integrated circuits 115 are formed, the through hole 590, and the through via 500 of FIG. 3D may be formed.

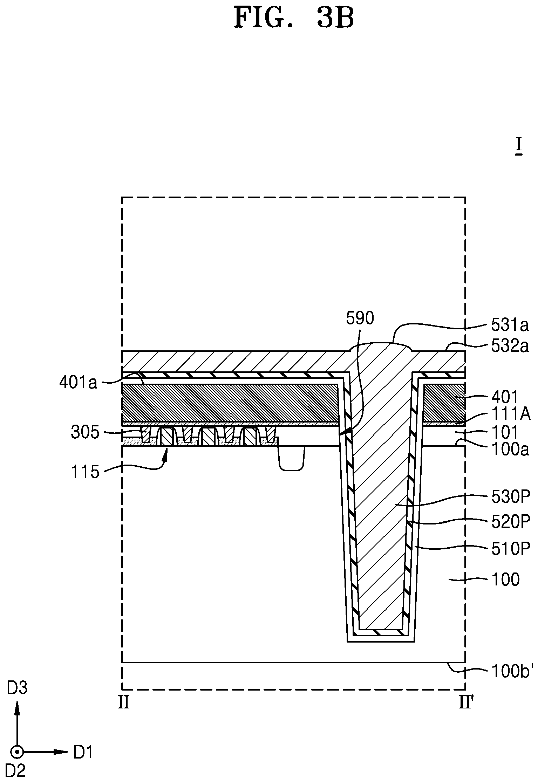

Referring to FIG. 3B, a preliminary isolation layer 510P may be conformally formed on the sidewall of the through hole 590 and an upper surface 401a of the protective layer 401. A preliminary barrier layer 520P may be formed within the through hole 590 and on the upper surface 401a of the protective layer 401 to conformally cover the preliminary isolation layer 510P. A preliminary conductive via 530P may be formed on the preliminary barrier layer 520P. Forming the preliminary conductive via 530P may include forming a seed layer and performing an electroplating process using the seed layer as an electrode. The through hole 590 may be filled with a conductive material by the electroplating process to form the preliminary conductive via 530P. The preliminary conductive via 530P may have a first upper surface 531a and a second upper surface 532a. In a plan view, the first upper surface 531a of the preliminary conductive via 530P may overlap the through hole 590. The second upper surface 532a of the preliminary conductive via 530P may be disposed on the upper surface 401a of the protective layer 401 in a plan view and may be spaced apart from the through hole 590 in a plan view. The second upper surface 532a of the preliminary conductive via 530P may be provided at a different level from the first upper surface 531a. The first upper surface 531a of the preliminary conductive via 530P might not be flat.

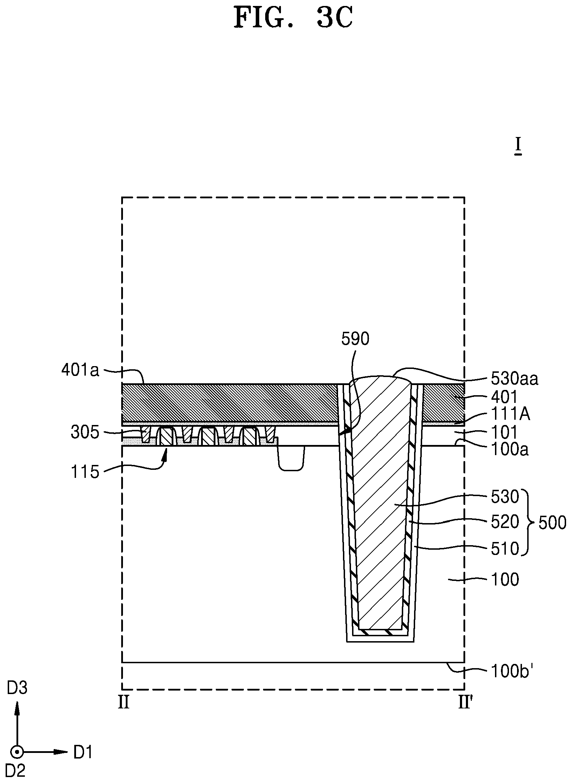

Referring to FIG. 3C, the preliminary conductive via 530P, the preliminary barrier layer 520P, and the preliminary isolation layer 510P may be planarized to form a conductive via 530, a barrier layer 520, and an isolation layer 510, respectively. The conductive via 530, the barrier layer 520, and the isolation layer 510 may be respectively formed within the through hole 590. Accordingly, a through via 500 may be manufactured. An upper sidewall of the through via 500 may be covered by the protective layer 401.

The planarization process may be performed by using a chemical mechanical polishing (CMP) process. The protective layer 401 may function as a stop layer of the planarization process. For example, the planarization process may be completed after the upper surface 401a of the protective layer 401 is exposed. The through via 500 may be localized within the through hole 590. During the planarization process, the preliminary conductive via 530P, the preliminary barrier layer 520P, and the preliminary isolation layer 510P may be removed from the upper surface 401a of the protective layer 401. Accordingly, after the planarization process is completed, an upper surface 530aa of the conductive via 530, an upper surface of the barrier layer 520, and an upper surface of the isolation layer 510 may be exposed. During the process of planarizing the preliminary conductive via 530P, non-uniformity in a minor error range may occur in the process. The preliminary conductive via 530P may have a relatively large width and height, and thus, the upper surface 530aa of the conductive via 530 after the planarization process might not be flat due to the non-uniformity in the minor error range in the process. A level of the upper surface 530aa of the conductive via 530 may have a relatively even distribution, for example the level of the upper surface 530aa of the conductive via 530 may vary within a predetermined or limited range. For example, the upper surface 530aa of the conductive via 530 may include a protruding portion and/or a recessed portion. For example, as illustrated in FIG. 3C, the upper surface 530aa of the conductive via 530 may protrude, for example the upper surface 530aa of the conductive via 530 may protrude upwardly relative to the exposed upper surface of the barrier layer 520, and the exposed upper surface of the isolation layer 510. The upper surface 530aa of the conductive via 530 may be upwardly convex. The conductive via 530 may have a center region and an edge region in a plan view. The edge region of the conductive via 530 may at least partially surround the center region in a plan view. The edge region of the conductive via 530 may be disposed between the center region of the conductive via 530 and the barrier layer 520. An upper surface of the center region of the conductive via 530 may be provided at a higher level than an upper surface of the edge region.

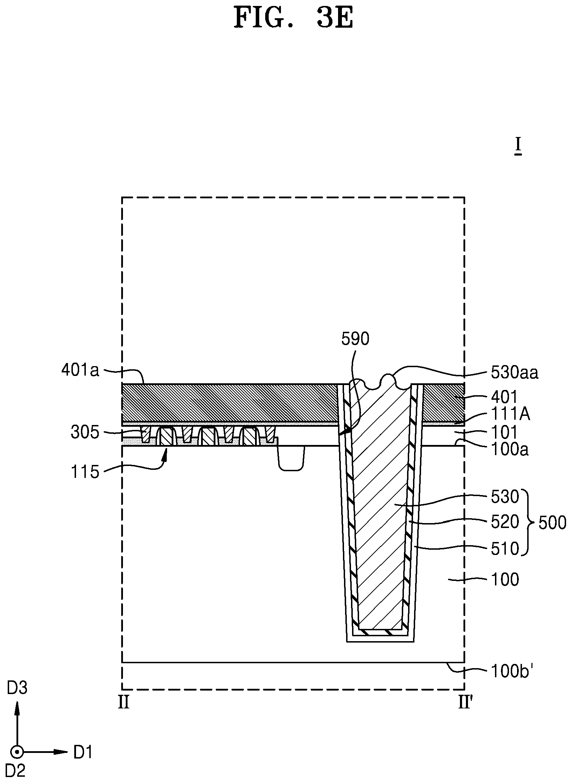

FIG. 3D is a cross-sectional view illustrating a through via after a planarization process, according to embodiments. FIG. 3E is a cross-sectional view illustrating a through via after a planarization process, according to embodiments.

Referring to FIG. 3D, the upper surface 530aa of the through via 500 may have a dish shape (e.g., like a bowl shape). For example, the upper surface 530aa of the conductive via 530 may be convex downwards, for example upwardly concave. The upper surface 530aa of the center region of the conductive via 530 may be provided at a lower level than the upper surface 530aa of the edge region of the conductive via 530. The upper surface 530aa of the center region of the conductive via 530 may be provided at a lower level than the upper surface 401a of the protective layer 401.

Referring to FIG. 3E, the upper surface 530aa of the through via 500 might not be flat. The upper surface 530aa of the conductive via 530 may have a protruding portion and a recessed portion. The protruding portion of the upper surface 530aa of the conductive via 530 may be provided at a higher level than the recessed portion of the upper surface 530aa.

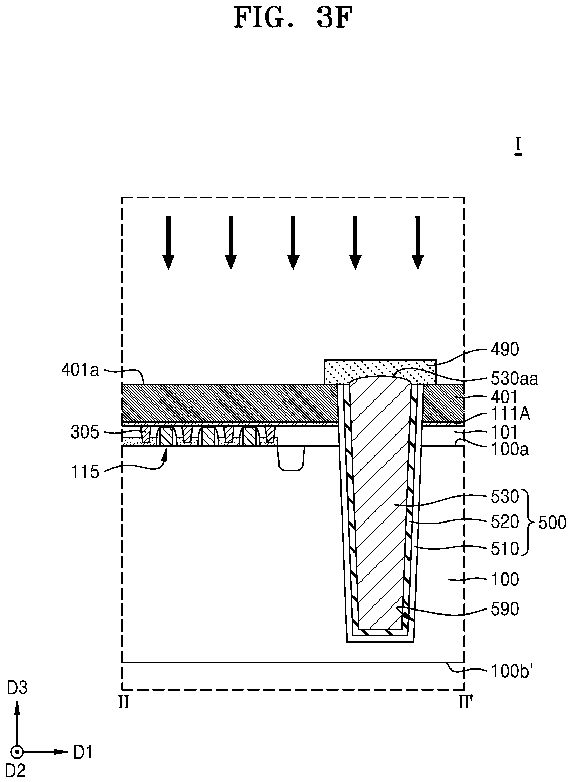

Hereinafter, for convenience, FIGS. 3F to 3I illustrate a case where the upper surface 530aa of the conductive via 530 of FIG. 3C protrudes, but the inventive concept is not necessarily limited thereto. The manufacturing method of FIGS. 3F to 3O may be substantially equally applied to the conductive via 530 of FIG. 3D and the conductive via 530 of FIG. 3E.

Referring to FIG. 3F, a mask pattern 490 may be formed on the upper surface 530aa of the through via 500. For example, the mask pattern 490 may cover the upper surface 530aa of the conductive via 530 and may cover a portion of the upper surface 401a of the protective layer 401. A width of the mask pattern 490 may be greater than a width of the through via 500. The difference between the width of the mask pattern 490 and the width of the through via 500 may be within a range of from 0.5 µm to 2 µm. The mask pattern 490 may include, for example, silicon carbonitride, silicon oxidized carbonitride, and/or a combination thereof. The protective layer 401 may include a first portion and a second portion. The first portion of the protective layer 401 may be covered by the mask pattern 490. The second portion of the protective layer 401 may be exposed by the mask pattern 490.

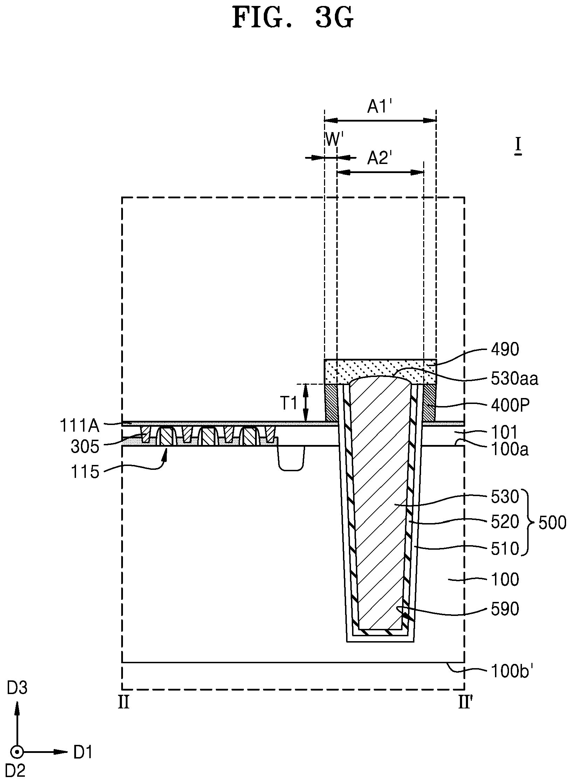

Sequentially referring to FIGS. 3F and 3G, an etching process may be performed on the protective layer 401 to form a preliminary protective barrier wall pattern 400P. The etching process may be performed by a dry etching process. The second portion of the protective layer 401 may be removed by the etching process, and the upper surface of the first etch stop layer 111A may be exposed. In the etching process, the first etch stop layer 111A may have etch selectivity with respect to the protective layer 401. An etch rate of the first etch stop layer 111A may be lower than an etch rate of the protective layer 401. Accordingly, the first etch stop layer 111A might not be removed. After the etching process is completed, the upper surface of the first etch stop layer 111A may be exposed.

The mask pattern 490 might not be removed in the etching process. The first portion of the protective layer 401 might not be exposed by the mask pattern 490 in the etching process. After the etching process is completed, the remaining first portion of the protective layer 401 may form the preliminary protective barrier wall pattern 400P. The preliminary protective barrier wall pattern 400P may cover the upper sidewall of the through via 500. The upper sidewall of the through via 500 might not be exposed by the etching process due to the preliminary protective barrier wall pattern 400P. Accordingly, damage to the through via 500 may be prevented.

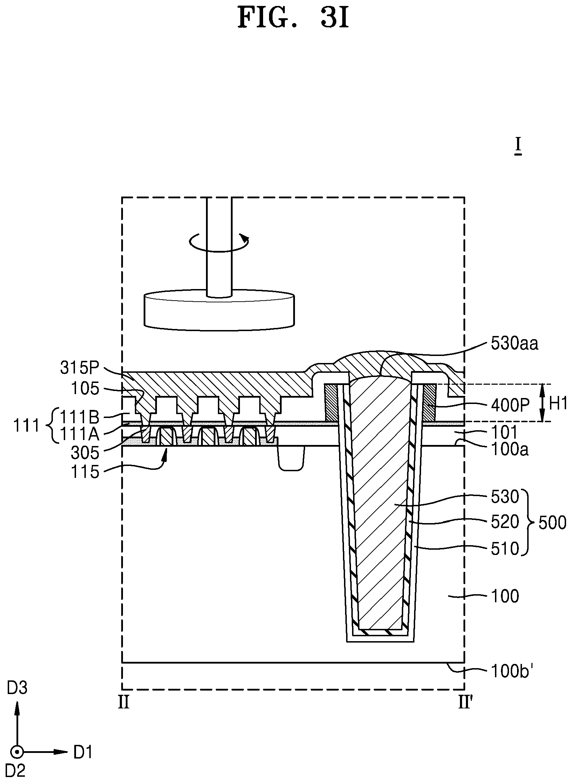

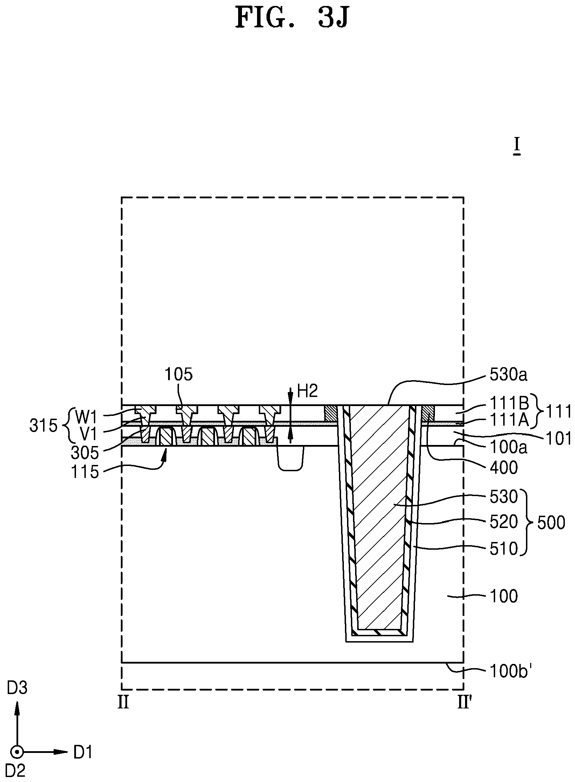

The width of the mask pattern 490 may be substantially the same as an outer diameter A1' of the preliminary protective barrier wall pattern 400P. The outer diameter A1' of the preliminary protective barrier wall pattern 400P may be substantially the same as the outer diameter A1 of the protective barrier wall pattern 400 described with reference to FIGS. 1B and 1D. The outer diameter A1' of the preliminary protective barrier wall pattern 400P may be 0.5 µm or more larger than a width A2' of the through via 500, and thus, the preliminary protective barrier wall pattern 400P may sufficiently protect the through via 500. The difference between the outer diameter A1' of the preliminary protective barrier wall pattern 400P and the width A2' of the through via 500 may be 2 µm or less, and thus, a space for forming the first wiring structures 315 described below with reference to FIGS. 3I and 3J may be secured. Accordingly, the semiconductor device may be miniaturized and made to be highly integrated.

A width W' of the preliminary protective barrier wall pattern 400P may be substantially the same as the width W of the protective barrier wall pattern 400 described with reference to FIGS. 1B and 1D. The width W' of the preliminary protective barrier wall pattern 400P may be 450 µm or more, and thus, the through via 500 may be stably protected. The width W' of the preliminary protective barrier wall pattern 400P may be 550 µm or less, and thus, the semiconductor device may be miniaturized.

After the etching process is completed, a cleaning process may be further performed. Residue from the etching process may be removed by the cleaning process. Hydrofluoric acid (HF), dilute hydrofluoric acid (DHF), or aerosol may be used in the cleaning process.

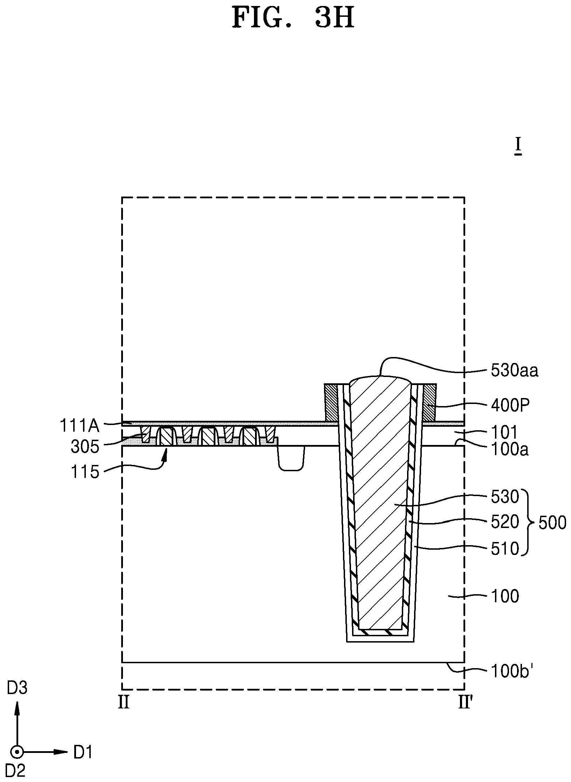

Referring to FIG. 3H, the mask pattern 490 may be removed to expose the upper surface of the through via 500 and an upper surface of the preliminary protective barrier wall pattern 400P. For example, the upper surface 530aa of the conductive via 530, the upper surface of the barrier layer 520, and the upper surface of the isolation layer 510 may be exposed.

Referring to FIG. 3I, a first interlayer insulating layer 111B may be formed on the first etch stop layer 111A, the preliminary protective barrier wall pattern 400P, and the through via 500 to cover an upper surface of the first etch stop layer 111A, an outer sidewall and an upper surface of the preliminary protective barrier wall pattern 400P, and the upper surface of the through via 500. For example, the first interlayer insulating layer 111B may cover the upper surface 530aa of the conductive via 530. Accordingly, a first insulating layer 111 including the first etch stop layer 111A and the first interlayer insulating layer 111B may be manufactured.

First openings 105 may be formed within the first etch stop layer 111A and within the first interlayer insulating layer 111B. Each of the first openings 105 may have a first via hole and a first trench. The first via hole may be formed within the first etch stop layer 111A to expose the conductive patterns 305. The first via hole may correspond to a lower portion of the corresponding first opening 105. The first trench may be formed within an upper portion of the first interlayer insulating layer 111B and may be connected to the first via hole. The first trench may correspond to an upper portion of the corresponding first opening 105. A width of the first trench may be greater than a width of the first via hole. The first openings 105 may be formed by an etching process. The first openings 105 may be formed by, for example, a dual damascene process. The first interlayer insulating layer 111B may further expose at least a portion of the upper surface 530aa of the conductive via 530.

A first conductive layer 315P may be formed on the first interlayer insulating layer 111B. The first conductive layer 315P may be formed within the first openings 105 to fill the first openings 105. The first conductive layer 315P may extend onto an upper surface of the first interlayer insulating layer 111B. For example, forming the first conductive layer 315P may include conformally forming a seed layer within the first openings 105 and on the first interlayer insulating layer 111B and performing an electroplating process using the seed layer as an electrode. The first conductive layer 315P may be electrically connected to the conductive patterns 305. The first conductive layer 315P may cover the exposed upper surface 530aa of the conductive via 530.

Sequentially referring to FIGS. 3I and FIG. 3J, a planarization process may be performed on the first conductive layer 315P to form first wiring structures 315. The planarization process may be performed by using a CMP process. An upper portion of the first conductive layer 315P may be removed by the planarization process. The upper portion of the first conductive layer 315P may be disposed on the upper surface of the first interlayer insulating layer 111B, the upper surface of the preliminary protective barrier wall pattern 400P, and the upper surface of the through via 500. Accordingly, the first wiring structures 315 may be localized within the first openings 105, and the upper surface of the first interlayer insulating layer 111B may be exposed. Each of the first wiring structures 315 may include a first via portion V1 and a first wiring portion W1. The first via portion V1 may be disposed within the first via hole of the first opening 105, and the first wiring portion W1 may be disposed within the first trench of the first opening 105.

During the planarization process, the first interlayer insulating layer 111B may be removed from the upper surface of the preliminary protective barrier wall pattern 400P and the upper surface of the through via 500. Subsequently, the preliminary protective barrier wall pattern 400P and the through via 500 may be planarized. An upper portion of the through via 500 may be removed by the planarization process. A height of the through via 500 and a height of the preliminary protective barrier wall pattern 400P before the planarization process may be relatively large. For example, the height (H1 in FIG. 3I) of the preliminary protective barrier wall pattern 400P may be 2 times to 2.5 times a height (H2 in FIG. 3J) of the first wiring structures 315. Accordingly, the through via 500 and the preliminary protective barrier wall pattern 400P may be sufficiently planarized. After the planarization process is completed, the upper surface of the through via 500 may be substantially flat. For example, the upper surface 530a of the conductive via 530 may be flat. The preliminary protective barrier wall pattern 400P may be planarized to form a protective barrier wall pattern 400. A height of the protective barrier wall pattern 400 may be less than the height (H1 in FIG. 3I) of the preliminary protective barrier wall pattern 400P. The upper surface of the through via 500 may be coplanar with an upper surface of the protective barrier wall pattern 400, the upper surface of the first interlayer insulating layer 111B, and the upper surfaces of the first wiring structures 315.

According to embodiments, the height (H1 in FIG. 3I) of the preliminary protective barrier wall pattern 400P may be two or more times greater than a height of the first wiring structures 315, and thus, the distribution of a level of the upper surface 530a of the conductive via 530 may be made more uniform. The height H1 of the preliminary protective barrier wall pattern 400P may be no more than 2.5 times the height of the first wiring structures 315, and thus, the efficiency of a manufacturing process of the semiconductor device may be increased.

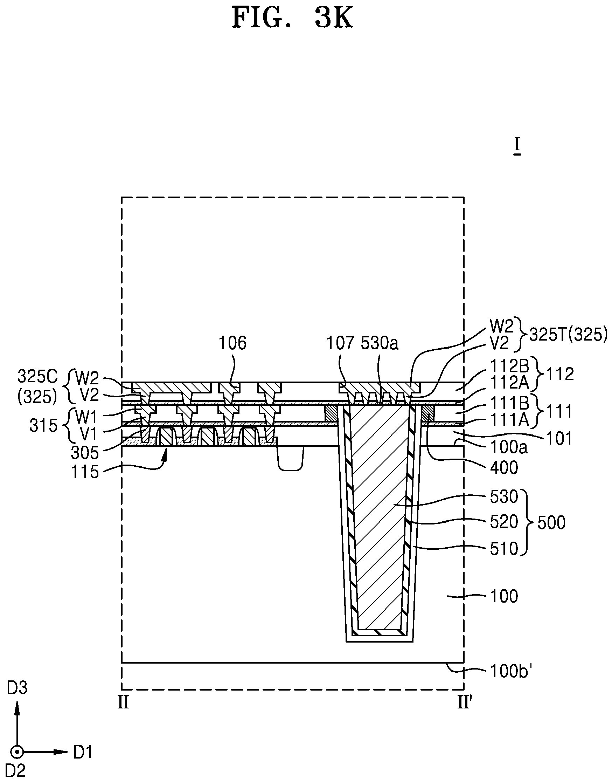

Referring to FIG. 3K, a second etch stop layer 112A may be formed on the first interlayer insulating layer 111B, the first wiring structures 315, and the protective barrier wall pattern 400. The second etch stop layer 112A may further cover the upper surface 530a of the conductive via 530. The second etch stop layer 112A may be formed by, for example, a deposition process. A second interlayer insulating layer 112B may be formed on the second etch stop layer 112A by the deposition process. Accordingly, a second insulating layer 112 including the second etch stop layer 112A and the second interlayer insulating layer 112B may be formed. Second openings 106 and a third opening 107 may be formed within the second insulating layer 112. The second openings 106 may be formed within the second etch stop layer 112A and the second interlayer insulating layer 112B to expose the first wiring structures 315. The third opening 107 may be formed within the second etch stop layer 112A and the second interlayer insulating layer 112B to expose the through via 500. Each of the second and third openings 106 and 107 may have a second via hole and a second trench. The second trench may be disposed on the second via hole and may be connected to the second via hole. The second trench may have a greater width than the second via hole.

Second wiring structures 325 may be formed within the second and third openings 106 and 107. For example, the second wiring structures 325 may include second circuit wiring structures 325C and a second through wiring structure 325T. The second circuit wiring structures 325C may be formed within the second openings 106. The second through wiring structure 325T may be formed within the third opening 107.

Forming the second wiring structures 325 may be performed using a method which is the same as, or which is similar to, the method used to previously form the first wiring structures 315. For example, forming the second wiring structures 325 may include forming a second conductive layer within the second and third openings 106 and 107 and on the second interlayer insulating layer 112B and performing a planarization process on the second conductive layer. Forming the second conductive layer may be performed by an electroplating process.

The planarization process may be performed by using a CMP process. An upper portion of the second conductive layer may be removed by the planarization process. Accordingly, the second wiring structures 325 may be localized within the second and third openings 106 and 107, and the upper surface of the second interlayer insulating layer 112B may be exposed. Each of the second wiring structures 325 may include a second via portion V2 and a second wiring portion W2. The second via portion V2 may be disposed within the second via hole, and the second wiring portion W2 may be disposed within the second trench.

According to embodiments, the distribution of the level of the upper surface 530a of the conductive via 530 may be made more consistent, and thus, electrical characteristics between the through via 500 and the second through wiring structure 325T and electrical characteristics between the first wiring structures 315 and the second circuit wiring structures 325C may be enhanced. For example, a resistance between the through via 500 and the second through wiring structure 325T may be reduced, may be more predictable, and/or may vary across a narrower range. For example, a resistance between the second circuit wiring structures 325C and the first wiring structures 315 may be reduced, may be more predictable, and/or may vary across a narrower range. Accordingly, reliability may be increased and electrical characteristics of the semiconductor device may be enhanced, for example the semiconductor device may exhibit a resistance which is reduced, more predictable, and/or which varies across a narrower range.

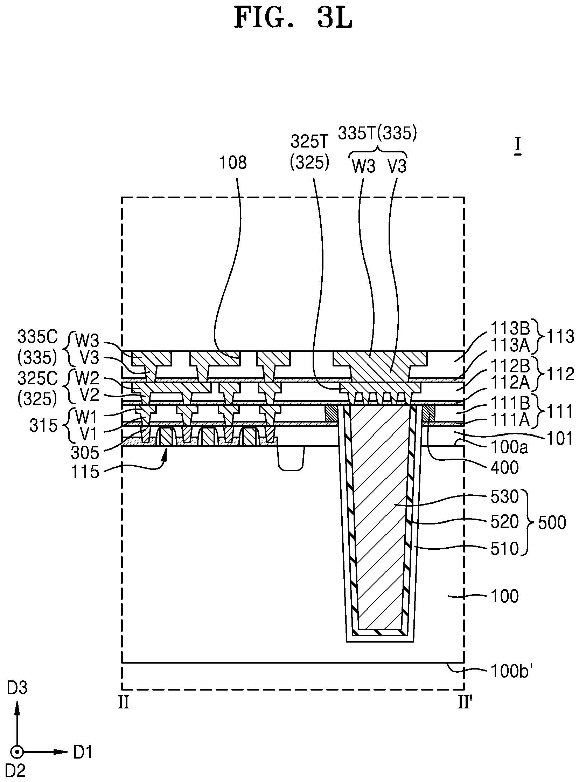

Referring to FIG. 3L, a third insulating layer 113 may be formed on both the second interlayer insulating layer 112B and the second wiring structures 325. Forming the third insulating layer 113 may include forming a third etch stop layer 113A and forming a third interlayer insulating layer 113B. The third etch stop layer 113A may be formed by a deposition process. The third interlayer insulating layer 113B may be formed by the deposition process.

Third wiring structures 335 may be formed within the third insulating layer 113. Forming the third wiring structures 335 may be performed using a method which is the same as, or which is similar to, the method used to previously form the second wiring structures 325. For example, fourth openings 108 may be formed within the third insulating layer 113. The fourth openings 108 may expose the second wiring structures 325. For example, forming the third wiring structures 335 may include forming a third conductive layer within the fourth openings 108 and on the third interlayer insulating layer 113B and performing a planarization process on the third conductive layer. The third wiring structures 335 may include third circuit wiring structures 335C and a third through wiring structure 335T. Each of the third wiring structures 335 may include a third wiring portion W3 and at least one third via portion V3.

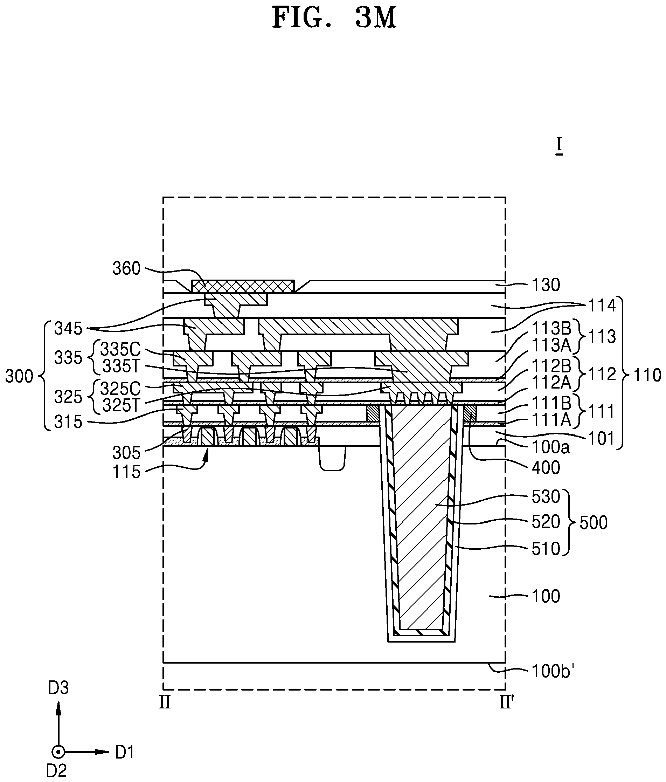

Referring to FIG. 3M, a fourth insulating layer 114 may be formed on the third interlayer insulating layer 113B and the third wiring structures 335. The fourth insulating layer 114 may be formed by a deposition process. Subsequently, the fourth wiring structures 345 may be formed within the fourth insulating layer 114 and may be electrically connected to the third wiring structures 335. Forming the fourth wiring structures 345 may be performed using a method which is the same as, or which is similar to, the method used to previously form the third wiring structures 335 described with reference to FIG. 3L.

The process of forming the fourth insulating layer 114 and the process of forming the fourth wiring structures 345 may be repeatedly performed to form a plurality of stacked fourth insulating layers 114 and a plurality of stacked fourth wiring structures 345.

An upper pad 360 may be formed on the uppermost fourth wiring structure 345 and the uppermost fourth insulating layer 114. A protective insulating layer 130 may be formed on the uppermost fourth insulating layer 114. A pad hole may be formed within the protective insulating layer 130 to expose the upper pad 360.

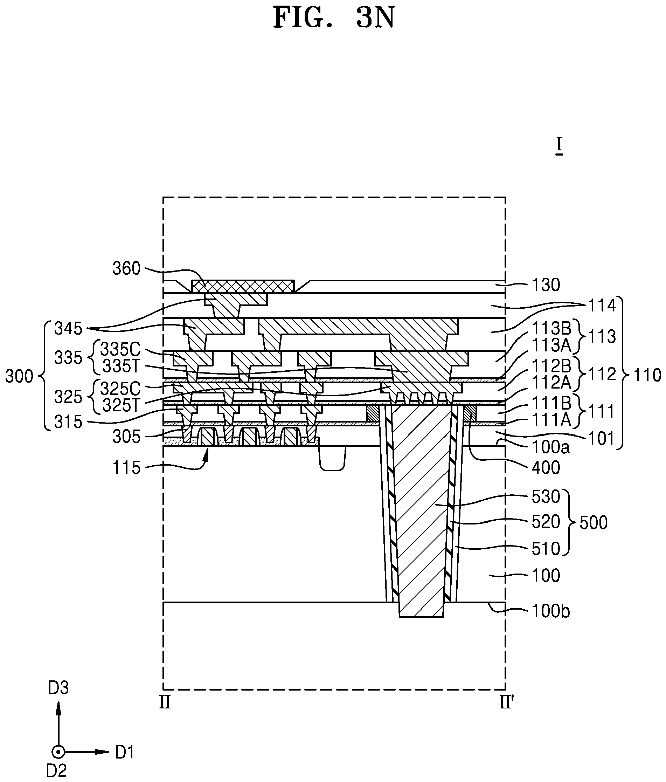

Referring to FIG. 3N, a thinning process may be performed on the second surface 100b' of the substrate 100, and thus, an end portion of the through via 500 may be exposed. The thinning process may be performed by a CMP process, an etch back process, or a combination thereof. A portion of the isolation layer 510 may be exposed on the thinned second surface 100b of the substrate 100. An exposed portion of the isolation layer 510 and a portion of the barrier layer 520 may be removed to expose an end portion of the conductive via 530. The removal of the exposed portion of the isolation layer 510 and the portion of the barrier layer 520 may be performed by an etch back process or an etching process.

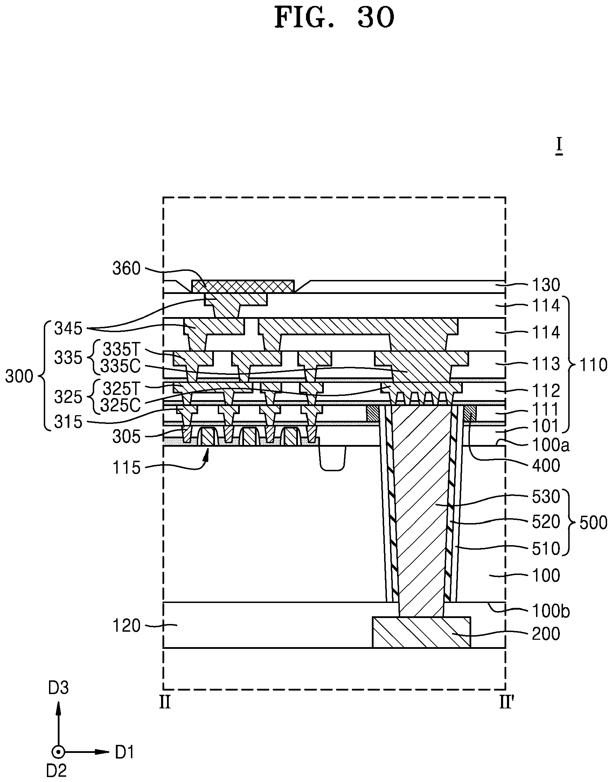

Referring to FIG. 3O, a backside insulating layer 120 may be formed on the second surface 100b of the substrate 100 to cover the second surface 100b of the substrate 100 and the end portion of the conductive via 530. A lower pad 200 may be formed on a lower surface of the backside insulating layer 120 or within the backside insulating layer 120 and may be electrically connected to the conductive via 530. A lower surface of the lower pad 200 may be exposed by the backside insulating layer 120.

Referring back to FIGS. 1A and 1C, a solder ball terminal 600 may be formed on the upper pad 360 of the substrate 100. As described above, manufacturing of the semiconductor device 10 may be completed.

According to embodiments, a preliminary protective barrier wall pattern and a through via may be formed at relatively large heights. The preliminary protective barrier wall pattern may form a protective barrier wall pattern by a planarization process. The through via may be sufficiently planarized by the planarization process. After the planarization process is completed, a distribution of a level of an upper surface of the through via may be made more uniform. Accordingly, electrical connection characteristics between through vias and wiring structures may be enhanced, for example a resistance between through vias and wiring structures may be reduced, may be more predictable, and/or may vary across a narrower range. A semiconductor device may have increased reliability and enhanced electrical characteristics, for example the semiconductor device may exhibit a resistance which is reduced, more predictable, and/or which varies across a narrower range.

While the inventive concept has been particularly shown and described with reference to embodiments thereof, it will be understood that various changes in form and details may be made therein without departing from the scope of the present disclosure.

## Claims

1. A semiconductor device (10), comprising:
a semiconductor substrate (100);
a first insulating layer (111) disposed on a first surface (100a) of the semiconductor substrate (100);
a through via (500) passing through both the semiconductor substrate (100) and the first insulating layer;
a protective barrier wall pattern (400) disposed within the first insulating layer (111) and on a sidewall (550c) of the through via (500);
a first wiring structure (315) disposed within the first insulating layer (111) and including a first via portion (V1) and a first wiring portion (W1); and
a second insulating layer (112) disposed on an upper surface of the first insulating layer (111) and at least partially covering an upper surface of the first wiring structure (315) and an upper surface of the protective barrier wall pattern (400).

2. The semiconductor device (10) of claim 1, further comprising a second through wiring structure (325T) disposed within the second insulating layer (112) and electrically connected to the through via (500),
wherein the second through wiring structure (325T) includes:
a plurality of second via portions (V2) laterally spaced apart from each other; and
a second wiring portion (W2) disposed on the plurality of second via portions (V2) and electrically connected to the plurality of second via portions (V2).

3. The semiconductor device (10) of claim 2, wherein the second insulating layer (112) is further disposed between the plurality of second via portions (V2).

4. The semiconductor device (10) of any preceding claim, wherein the second insulating layer (112) further covers at least a portion of an upper surface of the through via (500).

5. The semiconductor device (10) of any preceding claim, wherein an upper surface of the protective barrier wall pattern (400) is coplanar with an upper surface of the through via (500).

6. The semiconductor device (10) of any preceding claim, further comprising a lower insulating layer (101) disposed between the semiconductor substrate (100) and the first insulating layer (111), wherein the through via (500) further passes through the lower insulating layer (101), and the protective barrier wall pattern (400) does not extend between the lower insulating layer (101) and the through via (500).

7. The semiconductor device (10) of any preceding claim, wherein the first insulating layer (111) includes:
a first etch stop layer (111A); and
a first interlayer insulating layer (111B) disposed on the first etch stop layer (111A),
wherein the protective barrier wall pattern (400) is disposed on an upper surface of the first etch stop layer (111A), and the first via portion (V1) passes through the first etch stop layer (111A).

8. The semiconductor device (10) of claim 7, wherein the first etch stop layer (111A) includes a material that is different from a material of the protective barrier wall pattern (400).

9. The semiconductor device (10) of any preceding claim, further comprising:
a second circuit wiring structure (325C) disposed within the second insulating layer (112) and on an upper surface of the first wiring structure (315), and electrically connected to the first wiring structure (315); and
a second through wiring structure (325T) disposed within the second insulating layer (112) and on the through via (500), and electrically connected to the through via (500),
wherein the second through wiring structure (325T) is laterally spaced apart from the second circuit wiring structure (325C).

10. The semiconductor device (10) of claim 9, further comprising integrated circuits (115) disposed on the first surface (100a) of the semiconductor substrate (100), wherein the second circuit wiring structure (325C) is electrically connected to the integrated circuits (115) through the first wiring structure (315).

11. A semiconductor device (10), comprising:
a substrate (100);
a first insulating layer (111) disposed on a first surface (100a) of the substrate (100);
a through via (500) penetrating the substrate (100) and the first insulating layer (111);
a protective barrier wall pattern (400) disposed within the first insulating layer (111) and at least partially covering a sidewall (500c) of an upper portion of the through via (500); and
a first wiring structure (315) disposed within the first insulating layer (111) and including a first via portion (V1) and a first wiring portion (W1),
wherein an outer sidewall of the protective barrier wall pattern (400) is horizontally spaced apart from a sidewall of the first wiring portion (W1).

12. The semiconductor device (10) of claim 11, further comprising a second insulating layer (112) disposed on the first insulating layer (111), wherein the second insulating layer (112) covers an upper surface of the first wiring structure (315) and an upper surface of the protective barrier wall pattern (400).

13. The semiconductor device (10) of claim 12, wherein the second insulating layer (112) includes a second etch stop layer (112A) and a second interlayer insulating layer (112B) disposed on the second etch stop layer (112A), wherein the second etch stop layer (112A) is in physical contact with both the upper surface of the first wiring structure (315) and the upper surface of the protective barrier wall pattern (400).

14. The semiconductor device (10) of claim 12, further comprising a second through wiring structure (325T) disposed within the second insulating layer (112) and electrically connected to the through via (500),
wherein the second through wiring structure (325T) includes:
a second wiring portion (W2); and
a plurality of second via portions (V2) disposed between the through via (500) and the second wiring portion (W2) and laterally spaced apart from each other.

15. The semiconductor device (10) of claim 14, wherein the second insulating layer (112) is further disposed between the plurality of second via portions (V2) and between an upper surface of the through via (500) and a lower surface of the second wiring portion (W2).

## Amended claims

### Amended claims in accordance with Rule 137(2) EPC.

1. A semiconductor device (10), comprising:
a semiconductor substrate (100);
a first insulating layer (111) disposed on a first surface (100a) of the semiconductor substrate (100);
a through via (500) passing through both the semiconductor substrate (100) and the first insulating layer (111);
a protective barrier wall pattern (400) disposed within the first insulating layer (111) and on a sidewall (500c) of the through via (500);
a first wiring structure (315) disposed within the first insulating layer (111) and including a first via portion (V1) and a first wiring portion (W1); and
a second insulating layer (112) disposed on an upper surface of the first insulating layer (111) and at least partially covering an upper surface of the first wiring structure (315) and an upper surface of the protective barrier wall pattern (400),
wherein an upper surface of the protective barrier wall pattern (400) is coplanar with an upper surface of the through via (500), and
wherein the first insulating layer (111) includes:
a first etch stop layer (111A); and
a first interlayer insulating layer (111B) disposed on the first etch stop layer (111A),
wherein a lower surface of the protective barrier wall pattern (400) contacts with an upper surface of the first etch stop layer (111A), and the first via portion (V1) passes through the first etch stop layer (111A).

2. The semiconductor device (10) of claim 1, further comprising a second through wiring structure (325T) disposed within the second insulating layer (112) and electrically connected to the through via (500),
wherein the second through wiring structure (325T) includes:
a plurality of second via portions (V2) laterally spaced apart from each other; and
a second wiring portion (W2) disposed on the plurality of second via portions (V2) and electrically connected to the plurality of second via portions (V2).

3. The semiconductor device (10) of claim 2, wherein the second insulating layer (112) is further disposed between the plurality of second via portions (V2).

4. The semiconductor device (10) of any preceding claim, wherein the second insulating layer (112) further covers at least a portion of an upper surface of the through via (500).

5. The semiconductor device (10) of any preceding claim, further comprising a lower insulating layer (101) disposed between the semiconductor substrate (100) and the first insulating layer (111), wherein the through via (500) further passes through the lower insulating layer (101), and the protective barrier wall pattern (400) does not extend between the lower insulating layer (101) and the through via (500).

6. The semiconductor device (10) of any preceding claim, wherein the first etch stop layer (111A) includes a material that is different from a material of the protective barrier wall pattern (400).

7. The semiconductor device (10) of any preceding claim, further comprising:
a second circuit wiring structure (325C) disposed within the second insulating layer (112) and on an upper surface of the first wiring structure (315), and electrically connected to the first wiring structure (315); and
a second through wiring structure (325T) disposed within the second insulating layer (112) and on the through via (500), and electrically connected to the through via (500),
wherein the second through wiring structure (325T) is laterally spaced apart from the second circuit wiring structure (325C).

8. The semiconductor device (10) of claim 7, further comprising integrated circuits (115) disposed on the first surface (100a) of the semiconductor substrate (100), wherein the second circuit wiring structure (325C) is electrically connected to the integrated circuits (115) through the first wiring structure (315).

9. The semiconductor device (10) of claim 1,
wherein the protective barrier wall pattern (400) at least partially covers the sidewall (500c) of an upper portion of the through via (500); and
wherein an outer sidewall of the protective barrier wall pattern (400) is horizontally spaced apart from a sidewall of the first wiring portion (W1).

10. The semiconductor device (10) of claim 9, wherein the second insulating layer (112) includes a second etch stop layer (112A) and a second interlayer insulating layer (112B) disposed on the second etch stop layer (112A), wherein the second etch stop layer (112A) is in physical contact with both the upper surface of the first wiring structure (315) and the upper surface of the protective barrier wall pattern (400).

11. The semiconductor device (10) of claim 9, further comprising a second through wiring structure (325T) disposed within the second insulating layer (112) and electrically connected to the through via (500),
wherein the second through wiring structure (325T) includes:
a second wiring portion (W2); and
a plurality of second via portions (V2) disposed between the through via (500) and the second wiring portion (W2) and laterally spaced apart from each other.

12. The semiconductor device (10) of claim 11, wherein the second insulating layer (112) is further disposed between the plurality of second via portions (V2) and between an upper surface of the through via (500) and a lower surface of the second wiring portion (W2).
